# EUROPEAN PATENT SPECIFICATION

(11) **EP 4 095 442 B1**
(45) Date of publication and mention of the grant of the patent: **09.09.2026**
(21) Application number: 22176066.3
(22) Date of filing: 30.05.2022
(51) Int. Cl.: F24C 15/00, F24C 15/10, H05B 6/12

(54) **ELECTRIC RANGE**
ELEKTROHERD
CUISINIÈRE ÉLECTRIQUE

(30) Priority: 28.05.2021 KR 20210069400
(43) Date of publication of application: 30.11.2022
(73) Proprietor: LG Electronics Inc., Seoul 07336 (KR)
(72) Inventor: KIM, Hyunsoo, Seoul 08592 (KR); CHO, Junghyeon, Seoul 08592 (KR)
(74) Representative: Vossius & Partner Patentanwälte Rechtsanwälte mbB

(56) References cited:
- EP-A1- 3 996 470
- JP-A- 2004 079 401
- JP-A- 2015 207 398
- KR-A- 20150 137 756
- KR-B1- 100 813 730
- US-A1- 2018 152 992

## Description

An electric range, and more specifically, an electric range having a structure with improved wireless communication performance is disclosed herein.

Cooking apparatuses for heating food or other items (hereinafter, collectively "food") using various methods are used at homes and in restaurants. Cooking apparatuses include gas ranges using gas and electric ranges using electricity. Electric ranges are mainly divided into electric ranges which operate through resistance heating methods and electric ranges which operate through induction heating methods.

An electrical resistance method is a method of heating a heating target, for example, a cooking container, such as a pot or frying pan, by applying a current to a metal resistance wire or a nonmetal heating material, such as silicon carbide, to generate heat and radiating or conducting the generated heat. An induction heating method is a method of heating a heating target formed of a metal component using an eddy current generated by a magnetic field generated around a coil by applying high frequency power to the coil.

A basic heating principle of an induction heating method is that, when a current is applied to a working coil or heating coil, heat is generated while a heating target is induction-heated, and the heating target is heated by the generated heat.

In Korean Patent Registration 10-1307594, an electric range which operates through an induction heating method is disclosed. An electric range can be provided to wirelessly communicate with external devices in order for a user to conveniently remotely control the electric range, connection to other devices, or a server, for example, or implementation for the Internet of Things.

Accordingly, a wireless communication circuit board including a wireless communication module and a structure for installing the wireless communication circuit board can be provided in the electric range. For smooth wireless communication, the wireless communication circuit board needs to be provided in such a way that radio waves transmitted or received to or from external devices are not interfered with.

A structure for blocking electromagnetic fields and electromagnetic waves needs to be provided in the electric range. The blocking structure can block radio waves for communication that is transmitted from or received by the wireless communication circuit board. Accordingly, there can be a problem that the wireless communication circuit board does not smoothly communicate with the external devices due to such a blocking structure.

KR 100 813 730 B1 discloses an induction cooking apparatus, wherein the cooling performance of the induction cooking apparatus is improved by preventing cooling air from being circulated in the inside of the induction cooking apparatus.

Induction heating cookers of the prior art are further disclosed in KR 2015 0137756 A, US 2018/152992 A1, JP 2004-079401 A, EP 3 996 470 A1 and JP 2015-207398 A.

The present invention is defined by independent claim 1; the dependent claims describe embodiments of the present invention.

### BRIEF DESCRIPTION OF THE DRAWINGS

Embodiments will be described in detail with reference to the following drawings in which like reference numerals refer to like elements, and wherein:
FIG. 1 is a perspective view of an electric range according to an embodiment;
FIG. 2 is a perspective view of the electric range of FIG. 1 from which a cover plate is removed;
FIG. 3 is an exploded view of the electric range according to an embodiment;
FIG. 4 is a perspective view of the electric range of FIG. 1 from which some components are removed;
FIG. 5 is a front view of the electric range of FIG. 4.
FIG. 6 is a perspective view of an air guide according to an embodiment;
FIG. 7 is a perspective view of the air guide of FIG. 6 from another direction;
FIG. 8 is a plan view of the air guide according to an embodiment;
FIG. 9 is a bottom view of the air guide according to an embodiment;
FIG. 10 is a perspective view illustrating a state in which a printed circuit board is mounted on a base bracket according to an embodiment;
FIG. 11 is a plan view of the state of FIG. 10;
FIG. 12 is a perspective view of a heat sink according to an embodiment;
FIG. 13 is a front view of the heat sink according to an embodiment;
FIG. 14 is a perspective view of a base bracket according to an embodiment;
FIG. 15 is a plan view of the base bracket according to an embodiment;
FIG. 16 is a perspective view of a case according to an embodiment;
FIG. 17 is a plan view of the case according to an embodiment;
FIG. 18 a partially enlarged view illustrating a portion in which a element installation part according to an embodiment is disposed;
FIG. 19 is a view illustrating a state in which the wireless communication circuit board is installed in the portion of FIG. 18;
FIG. 20 is a plan view of the element installation part; and
FIG. 21 is a perspective view illustrating the element installation part.

Hereinafter, exemplary embodiments will be described with reference to the accompanying drawings. The same or similar elements are denoted by the same reference numerals in the drawings.

Although terms such as first, and second, for example, may be used for describing various elements, the elements are not limited by the terms. The terms are only used to distinguish one element from another element, and unless otherwise specifically described, a first element may also be a second element.

Throughout, unless specifically described otherwise, the number of elements may be one or a plurality.

Throughout, the term "vertical direction" denotes a vertical direction of an electric range in a state in which the electric range is installed for daily use. The term "left-right direction" denotes a direction perpendicular to the "vertical direction," and the term "front-rear direction" denotes a direction perpendicular to both the "vertical direction" and the "left-right direction." The term "bilateral direction" or "lateral direction" denotes the same direction as "left-right direction," and these terms may be interchangeably used in the present specification.

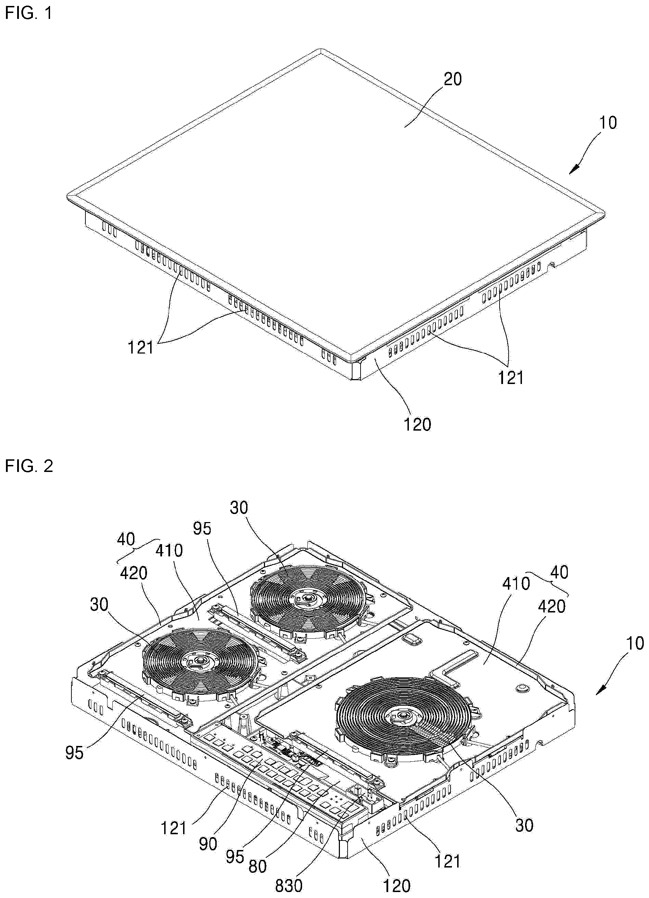

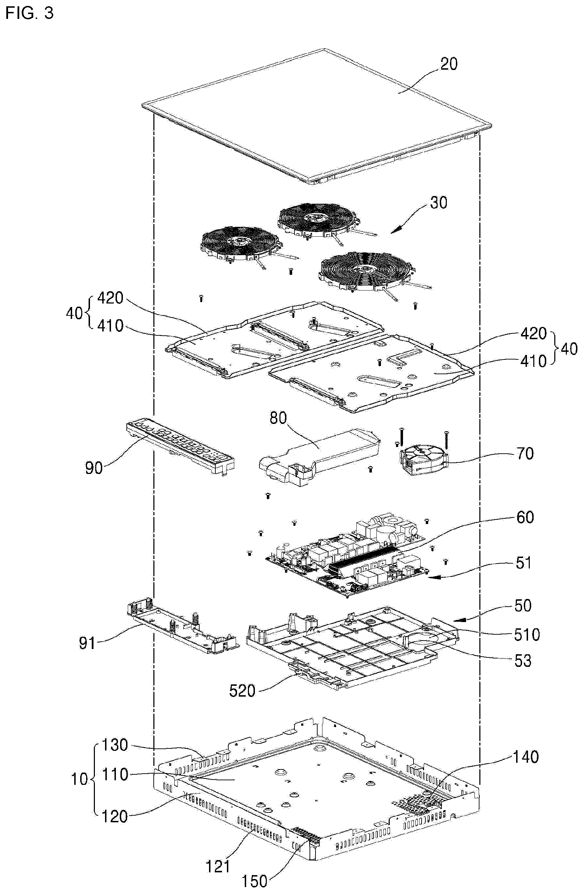

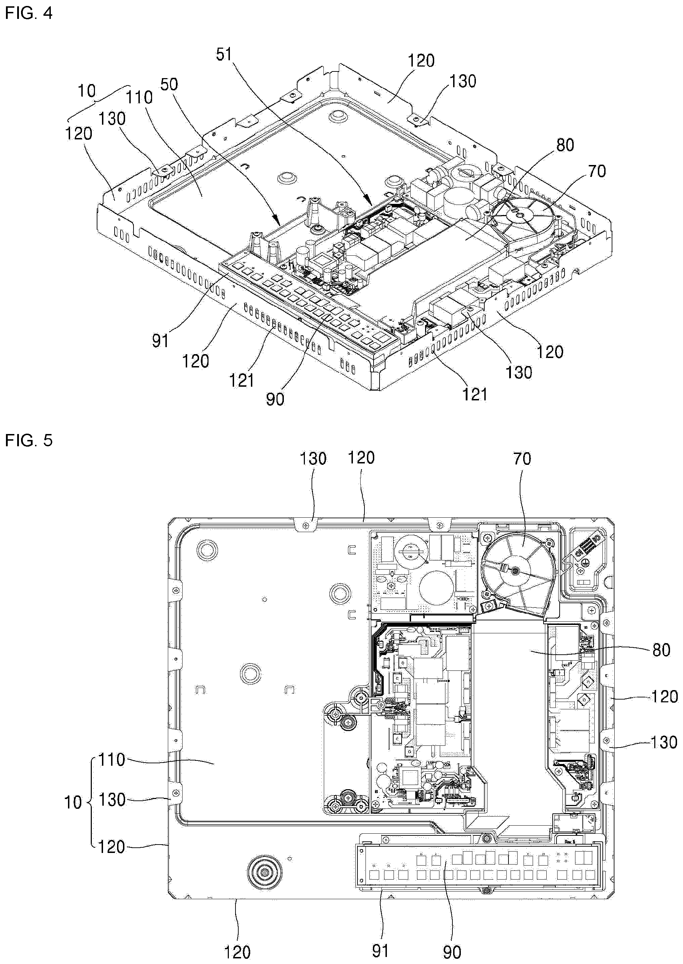

FIG. 1 is a perspective view of an electric range according to an embodiment. FIG. 2 is a perspective view of the electric range of FIG. 1 from which a cover plate is removed. FIG. 3 is an exploded view of the electric range according to an embodiment. FIG. 4 is a perspective view of the electric range of FIG. 1 from which some components are removed. FIG. 5 is a front view of the electric range of FIG. 4.

The electric range according to an embodiment may heat a heating target using an induction heating method. In this case, the heating target may be tableware formed of a metal material, such as stainless steel or iron.

The induction heating method is a method of heating a heating target formed of a metal component using an eddy current generated by a magnetic field generated around a working coil by applying high frequency power to the working coil. That is, high frequency power is applied to a working coil of a heating part (heater) 30 having a structure in which the working coil is close to a ferrite core to generate a magnetic field around the working coil, and when a heating target is placed in a region in which the magnetic field is generated, an eddy current is induced in the heating target by the magnetic field, Joule's heat is generated by the eddy current, and the heating target may be heated. As tableware which is the heating target is heated, food contained in the heating target may be heated and cooked.

The electric range according to an embodiment includes a case 10,
a cover plate 20, the heating part 30, an upper bracket 40, and may include a base bracket 50.
The case 10 may serve to protect components constituting the electric range. For example, the case 10 may be formed of an aluminum material; however, embodiments are not limited thereto. The case 10 may be thermally insulated to suppress heat generated by the working coil of the heating part 30 from being radiated to the outside.

The components constituting the electric range, such as the heating part 30, the working coil, the upper bracket 40, and a control board 90, may be accommodated in the case 10. An upper portion of the case 10 may be open, and the open portion may be closed by the cover plate 20. The case 10 may be substantially formed in a box shape by processing a plate type material, for example.

The case 10 may include a first casing 110, a second casing 120, and a third casing 130. The first casing 110 may form a bottom surface of the case 10. The first casing 110 may support built-in components of the electric range.

In the first casing 110, at least one vent opening, through which air flows, may be provided in order to smoothly cool a printed circuit board 51 provided in an inner portion thereof and circuit elements mounted on the printed circuit board 51.

The second casing 120 may be bent from the first casing 110 and may form a side surface of the case 10. The second casing 120 may be bent from an edge of the first casing 110 in a vertical direction to form a sidewall of the electric range.

The second casing 120 may be disposed on sides of the first casing 110 formed in a substantially quadrangular shape. The second casing 120 may reinforce a strength of an entirety of the case 10. That is, the second casing 120 bent from the first casing 110 may suppress the first casing 110 having a plate shape from being warped or damaged due to a weight of the built-in components or an external force.

The second casing 120 may further include a plurality of exhaust holes 121 formed in slit shapes. The exhaust holes 121 may allow an inside and outside of the case 10 to communicate with each other so that air flows through the exhaust holes 121 to contribute to cooling of the components accommodated in the case 10.

The third casing 130 may be bent from the second casing 120 and may support the upper bracket 40. The third casing 130 may be disposed above the sides of the first casing 110.

A first upper plate 410 forming a bottom surface of the upper bracket 40 may be seated on an upper surface of the third casing 130. The first upper plate 410 and the third casing 130 may be coupled by a coupling unit, such as a bolt, for example.

The cover plate 20 is coupled to an upper end of the case 10, and the heating target may be placed on an upper surface of the cover plate 20. The cover plate 20 may close the open upper portion of the case 10 to protect the components accommodated in the case 10.

The heating target may be placed on the upper surface of the cover plate 20, and a magnetic field generated by the heating part 30 may pass through the cover plate 20 and reach the heating target. For example, the cover plate 20 may be formed of a material containing a ceramic; however, embodiments are not limited thereto.

An input interface through which an input is received from a user may be installed on the upper surface of the cover plate 20. The input interface may be installed in a specific region of the upper surface of the cover plate 20 and may display a specific image.

A touch input may be received from the user through the input interface, and the electric range may be driven on the basis of the received touch input. For example, the input interface may be a module for a user to input a desired heating intensity or heating time and may be implemented as a physical button, or touch panel, for example. For example, the input interface may be a thin film transistor liquid crystal display (TFT LCD); however, embodiments are not limited thereto.

The control board 90 which inputs an operation command to the electric range may be provided under the cover plate 20. A plurality of key switches may be provided on the control board 90, and the user may input a command to the control board 90 through the plurality of key switches to control operation of the electric range.

In the electric range according to an embodiment, a board support 91 may be provided to stably install the control board 90 in the case 10. The board support 91 may be installed in the case 10, and the control board 90 may be installed on the board support 91.

The board support 91 may be manufactured in a shape that allows the board support 91 to be stably installed in the case 10 and allows the control board 90 to be stably mounted on the board support 91. The board support 91 may be formed of a plastic material, which is electrically insulative and is easily injection-molded, in order to be easy to manufacture, light, and electrically insulative; however, the material is not limited thereto.

In the electric range according to an embodiment, an upper surface of the control board 90 may be provided to be pressed against a lower surface of the cover plate 20. In this case, the control board 90 may be disposed at a position corresponding to the input interface. The control board 90 and the input interface may be connected to each other in a capacitive touch input manner. Accordingly, when the user inputs a control command through the input interface, the control command may be input to the control board 90.

In addition, a display on which a drive state of the electric range is displayed may be provided in a specific region of the upper surface of the cover plate 20. A light display region may be formed in the upper surface of the cover plate 20. A light source unit 95 may be disposed under the cover plate 20, and light emitted by the light source unit 95 may be transmitted to the user through the light display region.

In this case, the light display region and the light source unit 95 may be disposed at positions corresponding to each other. When a plurality of light source units 95 is provided, light display regions equal in number to the light source units 95 may also be provided in the upper surface of the cover plate 20.

A plurality of the heating part 30 may be provided and the plurality of heating parts 30, may be disposed under the cover plate 20, and may heat the heating target. The heating part 30 may be provided to operate through an induction heating method.

Hereinafter, an electric range in which all the plurality of heating parts 30 is provided to operate through the induction heating method will be described.

The heating parts 30 may be installed on the upper bracket 40, and in this embodiment, a total of three heating parts 30 may be provided. However, the number of the heating parts 30 is not limited thereto. When the plurality of heating parts 30 is provided, the upper bracket 40 that supports the heating parts 30 may also be provided as a plurality of upper brackets 40 as necessary.

The heating part 30 may include a core frame, the working coil may be spirally wound on an upper surface of the core frame, and the ferrite core may be installed on a lower surface of the core frame. Accordingly, when high frequency power is applied to the working coil, a magnetic field may be generated around the ferrite core, and the generated magnetic field may generate an eddy current in the heating target.

The upper bracket 40 is disposed under the heating part 30 and may support the heating part 30. For example, the upper bracket 40 may be formed of an aluminum material; however, embodiments are not limited thereto.

The upper bracket 40 may be manufactured as a structure that supports the heating part 30 by processing a plate metal in substantially a box shape, for example. The upper bracket 40 may include first upper plate 410 and second upper plate 420. The first upper plate 410 may form the bottom surface of the upper bracket 40, and the heating part 30 may be installed on the first upper plate 410.

The first upper plate 410 may hide the printed circuit board 51 provided thereunder in the vertical direction. When the plurality of upper brackets 40 is provided, one first upper plate 410 or a plurality of first upper plates 410 combined with each other may hide the printed circuit board 51 according to an area of the printed circuit board 51.

Due to this structure, the first upper plate 410 may serve to block an electromagnetic field and electromagnetic waves generated by the heating part 30 from reaching the printed circuit board 51 and elements mounted on the printed circuit board 51. That is, the upper bracket 40 may serve to improve the performance of electromagnetic compatibility (EMC) and electromagnetic interference (EMI) for the printed circuit board 51.

The second upper plate 420 may be bent from the first upper plate 410 in the vertical direction of the electric range. The second upper plate 420 may be bent from an edge of the first upper plate 410 in the vertical direction.

The second upper plate 420 may be disposed on sides of the first upper plate 410 formed in a substantially quadrangular shape. When the plurality of upper brackets 40 is provided, the second upper plate 420 may be provided on the sides of the first upper plate 410 excluding sides adjacent to each other of the upper brackets 40.

The second upper plate 420 may reinforce a strength of an entirety of the upper bracket 40. That is, the second upper plate 420 bent from the first upper plate 410 may suppress warping of or damage to the first upper plate 410 due to a weight of built-in components including the heating part 30 or an external force.

The light source unit 95 may be disposed under the upper bracket 40. For example, the light source unit 95 may be provided on the printed circuit board 51 disposed under the upper bracket 40, and an opening disposed at a position corresponding to the light source unit 95 may be formed in the upper bracket 40.

As described above, the light display region may be formed on the cover plate 20 at a portion corresponding to the light source unit 95. For example, the light source unit 95 may be provided in a form in which a plurality of light emitting diodes (LEDs) is arranged in a line.

When the heating part 30 operates, the light source unit 95 may be turned on to notify the user of whether the heating part 30 is used. Alternatively, the light source unit 95 may also change a lighting shape, or color, for example, of the plurality of LEDs to notify the user of a state in which the electric range is operating.

A number of the light source units 95 may be properly selected according to the number of the heating parts 30. In FIGS. 2 and 3, three light source units 95 are provided to correspond to three heating parts 30. However, the number of the light source units 95 is not limited thereto.

The base bracket 50 may be disposed under the upper bracket 40, the printed circuit board 51 may be installed on the base bracket 50, and the base bracket 50 may include a bottom plate and a side plate. The bottom plate may form a bottom surface of the base bracket 50, and the printed circuit board 51 may be installed on an upper surface of the base bracket 50.

The side plate may be bent from the bottom plate in the vertical direction of the electric range. The side plate may be bent from an edge of the bottom plate in the vertical direction.

The side plate may be disposed on sides of the bottom plate formed in a substantially quadrangular shape. When the plurality of upper brackets 40 is provided, the side plate may be formed on the sides of the bottom plate excluding sides adjacent to each other of the upper bracket 40.

The side plate may reinforce a strength of an entirety of the base bracket 50. That is, the side plate bent from the bottom plate may suppress the bottom plate having a board shape from being warped or damaged due to a weight of built-in components, such as the circuit board, or an external force.

The base bracket 50 may be formed of a plastic material, which is electrically insulative and is easily injection-molded, in order to be easy to manufacture, light, and electrically insulative; however, the material is not limited thereto.

A control part or portion may be formed on the printed circuit board 51. The printed circuit board 51 may receive power from an external power source and communicate with an external device in a wired or wireless manner.

A circuit board 93 may be installed in the electric range in order to wirelessly communicate with an external device. The printed circuit board 51 may be electrically connected to the circuit board 93.

The printed circuit board 51 may be electrically connected to the control board 90 and may receive a command input by the user from the control board 90. The printed circuit board 51 may be electrically connected to the light source unit 95 and the working coil and may control operation of the light source unit 95 and the working coil.

A heat sink 60 may be mounted on the printed circuit board 51. Various active and passive elements and electrical circuits for operation of the electric range may be mounted and formed on the printed circuit board 51.

The electric range according to the invention includes the heat sink 60, a blower fan 70, and an air guide 80. Elements that generate heat when the electric range operates may be mounted on the printed circuit board 51.

For example, in the electric range, switching elements responsible for on/off control of the heating parts 30 generate a lot of heat. Accordingly, the elements need to be forcibly cooled to suppress the electric range from stopping or a problem from occurring in the electric range due to overheating.

In the electric range according to an unclaimed example the heat sink 60, the blower fan 70, and the air guide 80 may be provided in order to forcibly cool heating of the elements of the printed circuit board 51. Hereinafter, elements that generate a lot of heat and need to be forcibly cooled are referred to as "heating elements 61".

The heat sink 60 may cool heat inside of the case 10 to protect components accommodated in the case 10. The heat sink 60 may be mounted on the printed circuit board 51 and cool heat of the circuit board. In addition, the heat sink 60 may cool heat generated due to an electromagnetic interaction when the heating part 30 operates.

For example, a plurality of cooling fins 610 may be formed on the heat sink 60, and the air guide 80 may be provided to cover the cooling fins 610 and guide air to flow to the cooling fins 610. The heat sink 60 and the cooling fins 610 will be described hereinafter with reference to the accompanying drawings.

The blower fan 70 may be installed on the base bracket 50 and to discharge air toward the heat sink 60. The blower fan 70 may be electrically connected to the printed circuit board 51, and operation of the blower fan 70 may be controlled by the control part or portion implemented on the printed circuit board 51.

Referring to FIG. 5, a guide wall, which guides a flow of air in a direction in which the heat sink 60 is disposed, may be formed at an exit of the blower fan 70 in order to guide the air, which is forcibly moved by the blower fan 70, to flow to the heat sink 60. When the blower fan 70 operates, air in the case 10 is forcibly moved toward the heat sink 60, and the printed circuit board 51 and on inner portion of the case 10 may be cooled by the heat sink 60.

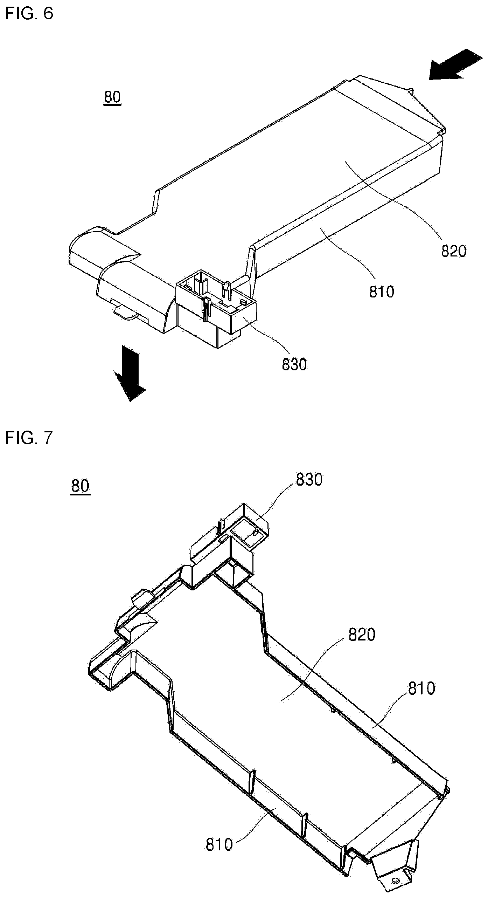

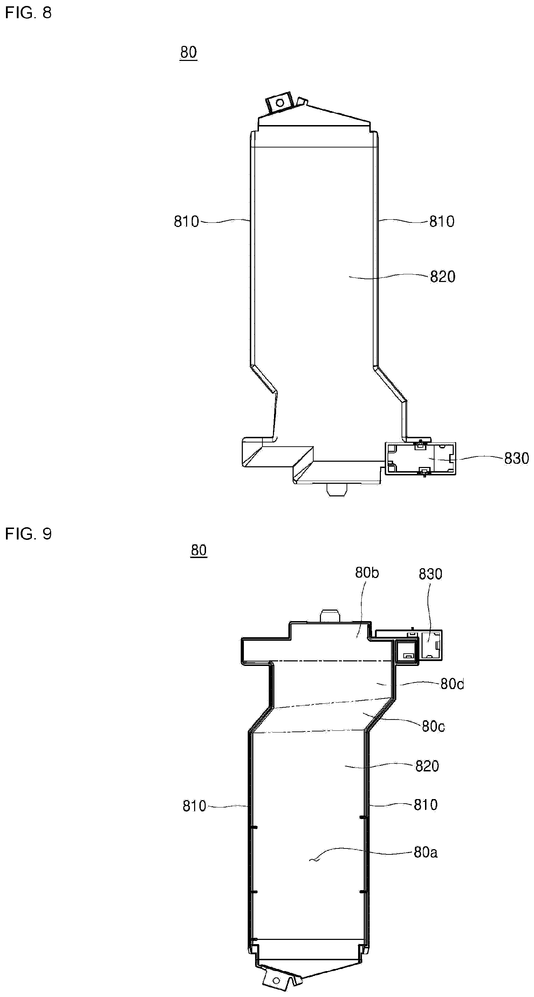

FIG. 6 is a perspective view of an air guide according to an embodiment. FIG. 7 is a perspective view of the air guide of FIG. 6 from another direction. FIG. 8 is a plan view of the air guide according to an embodiment. FIG. 9 is a bottom view of the air guide according to an embodiment.

The air guide 80 may communicate with the blower fan 70 and to surround the heat sink 60 to form a flow path of air which cools the heat sink 60. For example, the air guide 80 may be formed of a plastic material which is electrically insulative and is easily injection-molded; however, the material is not limited thereto.

Arrows illustrated in FIG. 6 indicate a flow direction of air. Referring to FIG. 6, the air guide 80 may change the flow direction of the air. That is, the air guide 80 may be formed so that air flows in a frontward-rearward direction of the electric range at an entrance of the air guide 80, and the air flows in the vertical direction of the electric range at an exit of the air guide 80. Due to such structure, air discharged by the blower fan 70 may flow into the air guide 80 in the frontward-rearward direction of the electric range and may be discharged from the air guide 80 in a downward direction of the electric range.

The air guide 80 may be detachably coupled to the base bracket 50. For example, a rear side of the air guide 80 adjacent to the blower fan 70 may be coupled to the base bracket 50 by a coupling unit, such as a screw bolt. In addition, for example, a front side of the air guide 80, which is a portion through which air is discharged, may be coupled to the base bracket 50 in an engagement manner.

The air guide 80 may include a first sidewall 810 and a second sidewall, and a flow space in which air flows may be formed by the first sidewall 810 and the second sidewall. The first sidewall 810 may be provided as a pair of first sidewalls 810 disposed at two sides of the heat sink 60. The upper wall 820 may be provided to be coupled to upper ends of the pair of first sidewalls 810 and to cover the heat sink 60.

A space formed by the first sidewalls 810 and the second sidewall may become the flow space in which the air flows. The heat sink 60 may be disposed in the flow space, and thus, the heat sink 60 may be cooled by air flowing in the flow space of the air guide 80.

A element installation part or portion 830 is provided in the air guide 80. The element installation part 830 is disposed in a portion that protrudes from an end portion of the air guide 80 in a lateral direction in a state in which the air guide 80 is installed in the electric range.

Due to such structure, the circuit board 93 installed in the element installation part 830 may not overlap the upper bracket 40 formed of a metal material in the vertical direction, and thus, the circuit board 93 may smoothly communicate with an external device without communication being interfered with by the upper bracket 40 formed of the metal material.

Referring to FIG. 9, the air guide 80 may include a first region 80a, a second region 80b, a third region 80c, and a fourth region 80d. The first region 80a to the fourth region 80d may be regions into which the flow space formed in the air guide 80 is divided.

The first region 80a may communicate with the blower fan 70 and may guide air to flow in a lateral direction of the base bracket 50. In this case, the heat sink 60 may be disposed in the first region 80a. Air flowing into the air guide 80 by the blower fan 70 may flow to the heat sink 60 and cool the heat sink 60 while passing through the first region 80a of the air guide 80.

The second region 80b may be bent in a vertical direction of the base bracket 50 and may guide air to be discharged to the outside. As the second region 80b is formed in the downward direction of the electric range, the second region 80b may change a flow direction of air flowing into the air guide 80.

That is, in the air guide 80, as the upper wall 820 is bent downward in the second region 80b, air discharged from the second region 80b may be guided toward a portion under the case 10. Due to the above-described structure, as illustrated by the arrows in FIG. 6, air discharged by the blower fan 70 may flow into the air guide 80 in the frontward-rearward direction of the electric range and discharged from the air guide 80 in the downward direction of the electric range.

The third region 80c and the fourth region 80d may be provided between the first region 80a and the second region 80b. The third region 80c may extend from the first region 80a and change a flow direction of air passing through the first region 80a. In the air guide 80, the first sidewall 810 is bent to be inclined at an end portion of the first region 80a to form the third region 80c.

That is, the first sidewall 810 may be inclined with respect to a frontward-rearward direction of the air guide 80 at an entrance of the third region 80c of the air guide 80. Due to such structure, in the third region 80c, air may flow in a direction inclined with respect to the frontward-rearward direction of the air guide 80.

As the third region 80c is formed as the above-described structure, when the air guide 80 is installed on the base bracket 50, elements disposed on the printed circuit board 51 may avoid meeting the first sidewall 810 at a portion overlapping the air guide 80 in the vertical direction. That is, the third region 80c may have an inclined structure due to a necessity to avoid the elements disposed on the printed circuit board 51.

The fourth region 80d may extend from the third region 80c, communicate with the second region 80b, and change a flow direction of air passing through the third region 80c. In the air guide 80, the first sidewall 810 is bent to be inclined at an end portion of the third region 80c to form the fourth region 80d.

That is, the first sidewall 810 at an exit of the third region 80c of the air guide 80 may be inclined with respect to the first sidewall 810 of the third region 80c. Due to such structure, in the fourth region 80d, a flow direction of air of the air guide 80 may be changed to the frontward-rearward direction of the air guide 80 again.

Air passing through the fourth region 80d may be discharged to a portion under the electric range through the second region 80b. Referring to FIG. 9, the flow direction of the air flowing in the air guide 80 to an exit of the fourth region 80d in the frontward-rearward direction of the electric range may be changed in the second region 80b, and the air may flow in the downward direction of the electric range through an exit of the second region 80b and may be discharged from the air guide 80.

As the upper wall 820 may be bent downward at the second region 80b, the air guide 80 may guide air discharged from the second region 80b to flow toward the portion under the case 10. That is, air may be discharged from the air guide 80 through the second region 80b illustrated in FIG. 9 and may flow in the downward direction of the electric range, that is, toward the portion under the case 10.

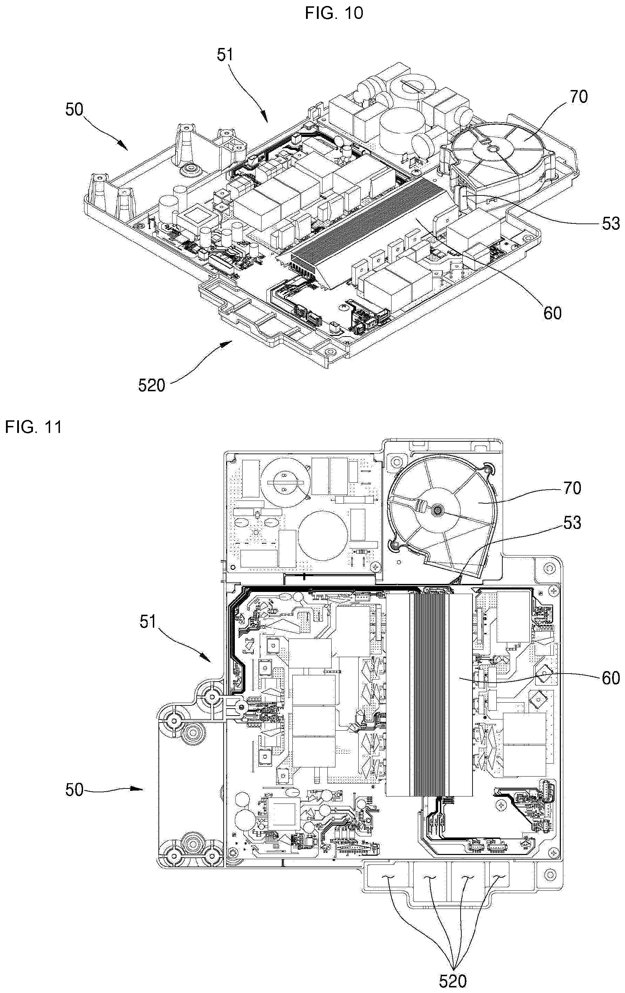

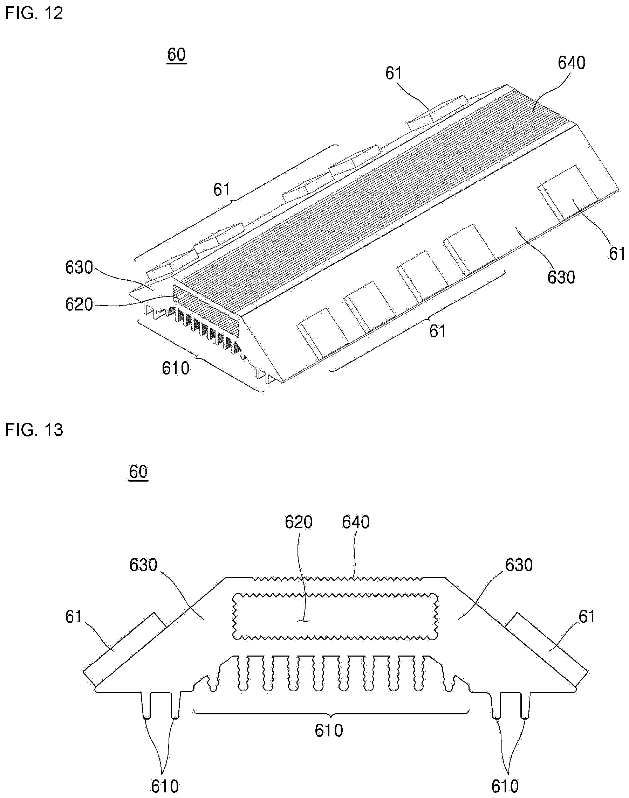

FIG. 10 is a perspective view illustrating a state in which the printed circuit board is mounted on the base bracket according to an embodiment. FIG. 11 is a plan view illustrating the state of FIG. 10. FIG. 12 is a perspective view of the heat sink according to an embodiment. FIG. 13 is a front view of the heat sink according to an embodiment.

A longitudinal direction of the heat sink 60 may extend parallel to a flow direction of air passing through the air guide 80. Due to such structure, cooling efficiency of the heat sink 60 may be improved by increasing a contact area and a contact time between the heat sink 60 and air which is forcibly moved. A longitudinal direction of the air guide 80 may also extend substantially parallel to a flow direction of air to correspond to the above-described layout of the heat sink 60.

As illustrated in FIGS. 12 and 13, the plurality of cooling fins 610 may be provided on the heat sink 60. The plurality of cooling fins 610 may protrude from a lower surface of the heat sink 60 in the downward direction and may extend parallel to the longitudinal direction of the heat sink 60. The cooling fins 610 may increase a contact area between the heat sink 60 and air to improve cooling efficiency of the heat sink 60.

The plurality of cooling fins 610 may be disposed on the lower surface of the heat sink 60 and spaced a proper or predetermined interval from each other in a widthwise direction of the heat sink 60. In this case, the cooling fins 610 may be formed on an inclined part or portion 630 and a flat part or portion 640 of the heat sink 60.

In addition, the heat sink 60 may include a flow pass 620 that passes through the heat sink 60 in the longitudinal direction and forms a flow path of air. The flow pass 620 may extend in the longitudinal direction of the heat sink 60 to pass through the flat part 640 of the heat sink 60.

The flow pass 620 may increase a contact area between the heat sink 60 and air like the cooling fin 610 to increase cooling efficiency of the heat sink 60. In this case, an irregular portion may be formed on an inner surface of the flow pass 620. The irregular portion may increase a contact area between the heat sink 60 and air to increase cooling efficiency of the heat sink 60.

The heat sink 60 may include the inclined part 630 disposed at two sides and having an inclined upper surface and the flat part 640 which is formed in a central portion, in which the flow pass 620 is formed, and an upper surface of which is formed as a flat surface.

An irregular portion may be formed on the upper surface of the flat part 640. The irregular portion may increase a contact area between the heat sink 60 and air to increase cooling efficiency of the heat sink 60.

All or some of the heating elements 61 provided on the printed circuit board 51 may be installed on the upper surface of the inclined part 630. Accordingly, air forcibly moved by the blower fan 70 may cool the heating elements 61 mounted on the inclined part 630 of the heat sink 60 to effectively suppress overheating of the printed circuit board 51.

The inclined part 630 may have a structure a thickness of which decreases toward an edge thereof. Accordingly, as the structure of the inclined part 630 serves a function similar to that of the cooling fin 610, the heating elements 61 installed on the inclined part 630 may be effectively cooled.

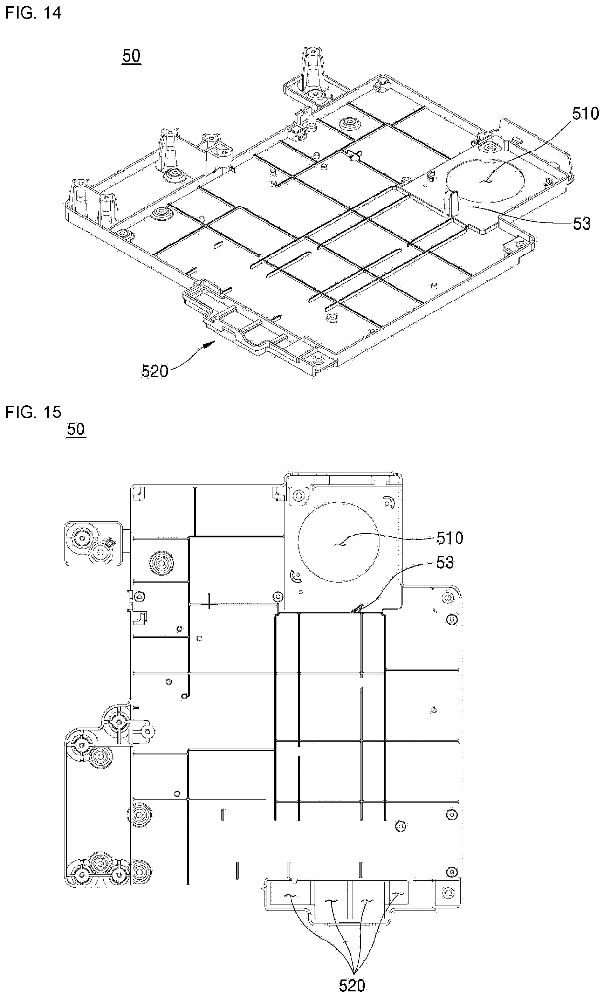

FIG. 14 is a perspective view of a base bracket according to an embodiment. FIG. 15 is a plan view of the base bracket according to an embodiment.

The base bracket 50 may include a first ventilation part or portion 510 formed in a portion corresponding to the blower fan 70 and a second ventilation part or portion 520 formed in a portion corresponding to the second region 80b. In this case, the first ventilation part 510 may be formed in a shape corresponding to a shape of the blower fan 70, and the second ventilation part 520 may be formed in a shape corresponding to a shape of the fourth region 80d.

When the blower fan 70 operates, air may flow upward from the first ventilation part 510 and may flow into the blower fan 70, a flow direction of the air may be changed by the blower fan 70, and the air may flow in the frontward-rearward direction of the electric range to pass through the air guide 80 and the heat sink 60. The flow direction of the air may be changed at the exit of the air guide 80 again, and the air may flow in the downward direction of the electric range, may pass through the second ventilation part 520, and may be discharged to the outside of the air guide 80.

A pair of the inclined part 630 of the heat sink 60 may be provided, and the pair of inclined parts 630 may be disposed at positions that are symmetrical with respect to a center of the flat part 640. The heating elements 61, which need to be cooled, may be disposed on the inclined parts 630.

Due to such structure, the heating elements 61 may be disposed at symmetrical positions at two sides of the heat sink 60. In order to uniformly cool the heating elements 61 disposed at the two sides of the heat sink 60, air discharged through the exit of the blower fan 70 needs to be guided to uniformly flow to the two sides of the heat sink 60. Accordingly, in order for the air to uniformly flow to the two sides of the heat sink 60, the electric range according to an unclaimed example may include a vane part or vane 53.

The vane part 53 may be disposed at a portion at which the blower fan 70 communicates with the air guide 80, and the air guide 80 may control a flow direction of air so that the air uniformly flows to the two sides of the heat sink 60. For example, the vane part 53 may be formed on the base bracket 50. As another unclaimed example, vane part 53 may be integrally formed with air guide 80 at the entrance of the air guide 80. As still another unclaimed example, vane part 53 may also be integrally formed with a housing of blower fan 70 at the exit of the blower fan 70.

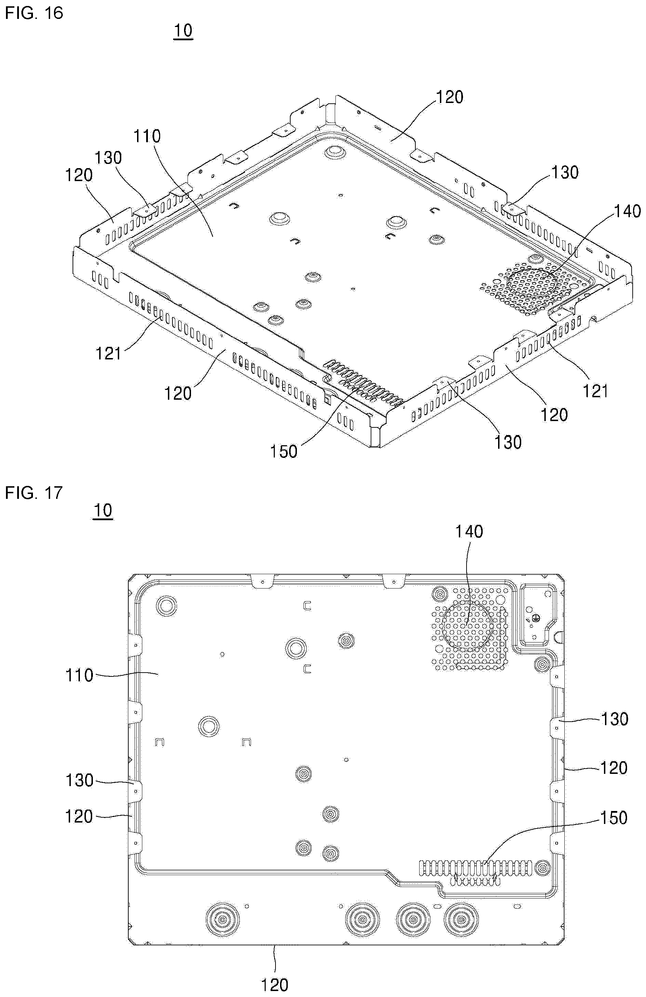

FIG. 16 is a perspective view of a case according to an embodiment. FIG. 17 is a plan view illustrating the case according to an embodiment.

The case 10 may include a first through port 140 and a second through port 150 in order to allow air to be forcibly moved by the blower fan 70 to effectively flow and be discharged.

The first through port 140 may be formed in a portion corresponding to the first ventilation part 510, and the second through port 150 may be formed in a portion corresponding to the second ventilation part 520. The first through port 140 and the second through port 150 may be formed by punching the first casing 110 forming the bottom surface of the case 10, for example.

A plurality of the first through port 140 and the second through port 150 may be provided. As the case 10 is an outermost wall of the electric range, the first through port 140 and the second through port 150 may be formed as holes having relatively small areas, and the plurality of first through ports 140 and the plurality of second through ports 150 may be formed in order to suppress external matter from flowing into the electric range through the first through ports 140 and the second through ports 150 formed in the case 10.

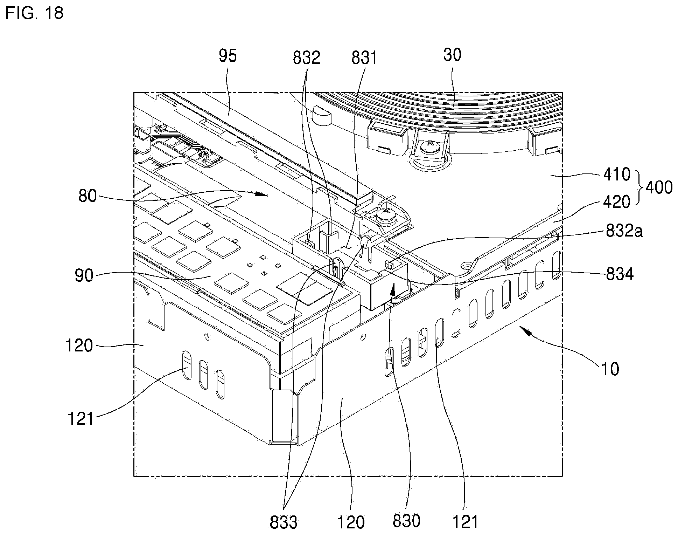

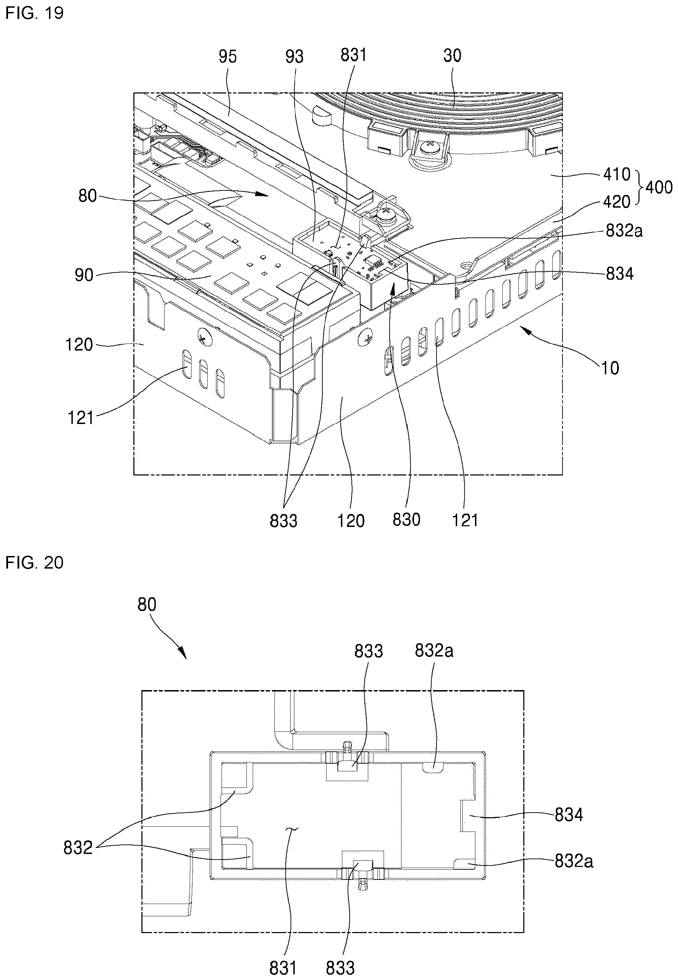

FIG. 18 a partially enlarged view illustrating a portion in which the element installation part 830 according to an embodiment is disposed. FIG. 19 is a view illustrating a state in which the circuit board 93 is installed in the portion of FIG. 18.

The electric range is provided to wirelessly communicate with an external device in order for the user to conveniently remotely control the electric range, connection to other devices, or a server, for example, or implementation for the Internet of Things. Accordingly, the circuit board 93 including wireless communication modules may be installed in the electric range. For example, the circuit board 93 may include various wireless communication modules, such as a Wi-Fi communication module and/or a Bluetooth communication module.

In addition, the electric range may include structure for installing the circuit board 93. For smooth wireless communication, radio waves for transmission and reception that are transmitted and received between the circuit board 93 and an external device should not be interfered with. The electric range needs to include structure which blocks an electromagnetic field and electromagnetic waves, and the blocking structure may block radio waves for communication that are transmitted from and received by the circuit board 93.

For example, the upper bracket 40 may be formed of a metal material, for example, an aluminum material, in order to block an electromagnetic field and electromagnetic waves generated by the heating part 30 from reaching the printed circuit board 51 and the elements mounted on the printed circuit board 51. Accordingly, due to such a blocking structure, there may be a problem that the circuit board 93 may not smoothly communicate with an external device. In an embodiment, the circuit board 93 avoids the structure blocking an electromagnetic field and electromagnetic waves, and a structure capable of smoothly communicating with the external device is provided.

Further, the circuit board 93 needs to be disposed apart from the working coil in a lateral direction of the electric range such that communication is not interfered with due to an electromagnetic field or electromagnetic waves generated by the working coil provided in the heating part 30 disposed on the upper bracket 40. Furthermore, the circuit board 93 needs to be disposed in the upper portion in the case 10 such that communication is not interfered with due to an electromagnetic field or electromagnetic waves generated by an electrical device, such as the printed circuit board 51, installed in the case 10 and an external power source connection device.

As described above, the air guide 80 may include the element installation part 830. The element installation part 830 may be disposed in the portion that protrudes from the end portion of the upper bracket 40 in the lateral direction, and the circuit board 93 may be installed in the element installation part 830.

The circuit board 93 may be integrally formed with the air guide 80. For example, the circuit board 93 may be integrally formed with the air guide 80 in an injection molding manner. However, embodiments are not limited thereto, and the circuit board 93 may be individually manufactured and coupled to the air guide 80.

Referring to FIGS. 1, 2, 18, and 19, the element installation part 830 may be disposed at a position which overlaps the cover plate 20 in the vertical direction and does not overlap the upper bracket 40. The upper bracket 40 may be manufactured of the metal material capable of interfering with radio waves transmitted from and received by the circuit board 93 installed in the element installation part 830. Accordingly, in order for the circuit board 93 to smoothly transmit and receive radio waves, the element installation part 830 may be disposed at the position which does not overlap the upper bracket 40 in the vertical direction of the electric range. Due to such structure, as the circuit board 93 is disposed at the position which does not overlap the upper bracket 40 in the vertical direction of the electric range, communication may not be interfered with by the upper bracket 40, and smooth wireless communication with an external device is possible.

As the cover plate 20 is formed of a nonmetal material, such as a material containing a ceramic, the cover plate 20 does not interfere with radio wave transmission and reception of the circuit board 93. Thus, the cover plate 20 and the element installation part 830 may be provided to overlap in the vertical direction of the electric range.

Accordingly, referring to FIG. 19, the circuit board 93 is installed in the element installation part 830 so that an upper surface of the circuit board 93 is provided to face the cover plate 20. Due to such structure, the circuit board 93 installed in the element installation part 830 may be disposed in the upper portion of the case 10 to effectively suppress interference of an electromagnetic field or electromagnetic waves generated by the electrical devices installed in the case 10 and thus may smoothly wirelessly communicate with an external device. In addition, the cover plate 20 may protect the element installation part 830 such that the element installation part 830 is not exposed to the outside.

The electric range according to an embodiment may further include the control board 90 disposed under the cover plate 20 spaced apart from the upper bracket 40 in the lateral direction. The control board 90 has been described above.

In this case, the element installation part 830 may be disposed between the upper bracket 40 and the control board 90 in the lateral direction of the electric range. Accordingly, the circuit board 93 installed in the element installation part 830 may not overlap the control board 90 and the upper bracket 40 in the vertical direction of the electric range. Accordingly, the circuit board 93 may smoothly communicate with an external device without communication being interfered with by the control board 90. Due to such structure, the circuit board 93 may smoothly operate while avoiding communication interference of the control board 90 and the upper bracket 40, and spatial efficiency of the electric range may be improved. In addition, as the circuit board 93 may be disposed at a position sufficiently spaced apart from the working coil disposed on the upper bracket 40, communication interference from an electromagnetic field or electromagnetic waves generated by the working coil can be effectively suppressed.

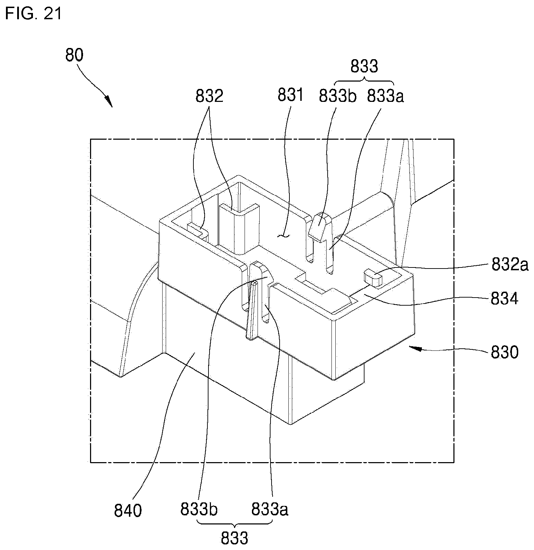

FIG. 20 is a plan view of a element installation part. FIG. 21 is a perspective view of the element installation part 830.

As illustrated in FIGS. 20 and 21, the element installation part 830 may include an arrangement groove 831, a element support 832, and an installation hook 833. The arrangement groove 831 may be formed to be concave downward, and the circuit board 93 may be disposed in the arrangement groove 831. The circuit board 93 may be inserted into the arrangement groove 831 and installed in the element installation part 830.

The element support 832 may be formed inside of the arrangement groove 831 and may support a lower surface of the circuit board 93. The element support 832 may be integrally formed with the element installation part 830, may protrude from an inner surface of a sidewall and a lower surface of the arrangement groove 831, and may contact the lower surface of the circuit board 93 installed in the arrangement groove 831 to stably support the circuit board 93.

An auxiliary support 832a may be formed in the arrangement groove 831. The auxiliary support 832a may be integrally formed with the element installation part 830 and protrude from an inner surface of a sidewall of the arrangement groove 831. Along with the element support 832, the auxiliary support 832a may be in contact with a lower surface of the circuit board 93 installed in the arrangement groove 831 to support the circuit board 93.

The installation hook 833 may be formed on a wall surface forming the arrangement groove 831 and may detachably install the circuit board 93 in the element installation part 830. The installation hook 833 may be integrally formed with the element installation part 830 and provided to be elastically deformable when the circuit board 93 is installed and separated.

The circuit board 93 may include a first shell 833a and a second shell 833b. The first shell 833a may be formed so that a part or portion of the sidewall of the arrangement groove 831 is recessed, and a part or portion of the recessed sidewall of the arrangement groove 831 protrudes upward.

The second shell 833b may be integrally formed with the first shell 833a and provided in a hook shape at an upper end portion of the first shell 833a. In this case, a stepped portion having a rectangular shape is present at a lower end of the second shell 833b, and an inclined surface may be formed on the stepped portion toward an upper end thereof.

Due to such structure, when an operator places the circuit board 93 in the arrangement groove 831 and presses the circuit board 93 downward, the first shell 833a may be elastically deformed, and the circuit board 93 may be stably installed in the arrangement groove 831. After the operator applies a force to the installation hook 833 and elastically deforms the installation hook 833, the operator may separate the circuit board 93 installed in the arrangement groove 831 from the arrangement groove 831.

An auxiliary hook 834 may be provided in the arrangement groove 831 in a direction perpendicular to a direction in which the first shell 833a is elastically deformed. The auxiliary hook 834 may protrude from an inner surface of a wall of the arrangement groove 831. Along with the installation hook 833, the auxiliary hook 834 may serve to tightly hold the circuit board 93 such that the circuit board 93 installed in the arrangement groove 831 is not easily separated from the arrangement groove 831.

The element installation part 830 may include a second support 840. The second support 840 may be integrally formed with the element installation part 830, may be disposed on the lower surface of the arrangement groove 831, and may support the arrangement groove 831.

As the arrangement groove 831 protrudes from one side of the air guide 80, the second support 840 is provided at the air guide 80 at a lower side of the arrangement groove 831 from a portion in which the arrangement groove 831 is formed. Thus, a structure in which the second support 840 stably supports the arrangement groove 831 may be provided.

In the present invention, an electric range as defined by claim 1 is provided.

Embodiments disclosed herein provide an electric range having a structure capable of smoothly wirelessly communicating with an external device. Further, embodiments disclosed herein provide an electric range having a structure in which a circuit board provided in the electric range is capable of transmitting and receiving radio waves while avoiding an electromagnetic field and wave blocking structure. Furthermore, embodiments disclosed herein provide an electric range having a structure in which radio wave transmission and reception of a circuit board are not interfered with by an upper bracket formed of a metal material.

Advantages are not limited to the above-described advantages, and other advantages may be understood from the descriptions and clearly understood from embodiments.

In an electric range according to embodiments disclosed herein, as a circuit board avoids structure which blocks an electromagnetic field and electromagnetic waves, the circuit board may smoothly wirelessly communicate with an external device. Further, in the electric range according to embodiments disclosed herein, as the circuit board is disposed at a position which does not overlap the upper bracket in a vertical direction of the electric range, the circuit board may smoothly wirelessly communicate with the external device without radio waves being interfered with by the upper bracket. Furthermore, in the electric range according to embodiments disclosed herein, the circuit board may avoid communication interference from a control board and the upper bracket and may operate smoothly, and spatial efficiency of the electric range may be improved.

It will be understood that when an element or layer is referred to as being "on" another element or layer, the element or layer can be directly on another element or layer or intervening elements or layers. In contrast, when an element is referred to as being "directly on" another element or layer, there are no intervening elements or layers present. As used herein, the term "and/or" includes any and all combinations of one or more of the associated listed items.

It will be understood that, although the terms first, second, third, etc., may be used herein to describe various elements, components, regions, layers and/or sections, these elements, components, regions, layers and/or sections should not be limited by these terms. These terms are only used to distinguish one element, component, region, layer or section from another region, layer or section.

Embodiments are described herein with reference to cross-section illustrations that are schematic illustrations of idealized embodiments (and intermediate structures). As such, variations from the shapes of the illustrations as a result, for example, of manufacturing techniques and/or tolerances, are to be expected.

## Claims

1. An electric range, comprising:
a case (10);
a cover plate (20) coupled to an upper side of the case (10) and having an upper surface on which a heating target can be disposed;
a plurality of heating parts (30) disposed under the cover plate (20) and configured to heat the heating target;
an upper bracket (40) which is disposed under the plurality of heating parts (30) and supports the plurality of heating parts(30); and
an air guide (80) forming a flow path of air, wherein the air guide (80) includes an element installation portion (830) which is disposed in a portion of the air guide (80);
a circuit board (93) in order to wirelessly communicate with an external device;
a blower fan (70) configured to discharge air; and
a heat sink (60) installed on a printed circuit board (51),
wherein the circuit board (93) is installed in the element installation portion (830), and
wherein the circuit board (93) is provided as a wireless communication board in order to wirelessly communicate with the external device.
**characterized in that**
the element installation portion (830) protrudes in a lateral direction and in which the circuit board (93) is installed,
the element installation portion (830) is disposed in a portion that protrudes from an end portion of the upper bracket (40) in a lateral direction,
the element installation portion (830) is disposed at a position which overlaps the cover plate (20) in a vertical direction and avoids overlapping with the upper bracket (40), and
an upper surface of the circuit board (93) is arranged to face the cover plate (20).

2. The electric range of claim 1,
wherein the circuit board (93) is integrally formed with the air guide (80).

3. The electric range of claim 2, further comprising a control board (90) disposed under the cover plate (20), wherein the element installation portion (830) is disposed at a side of the control board (90) in the lateral direction.

4. The electric range of claim 2 or 3, wherein the element installation portion (830) includes:
an arrangement groove (831) which is concave downward and in which the circuit board (93) is disposed;
a element support (832) which is disposed inside of the arrangement groove (831) and supports a lower surface of the circuit board (93); and
an installation hook (833) formed on a wall surface forming the arrangement groove (831) and configured to allow the circuit board (93) to be detachably installed in the element installation portion (830).

5. The electric range of any one of claims 2 to 4, further comprises a base bracket (50) on which the printed circuit board (51) is installed,
wherein the air guide (80) includes:
a first region (80a) that communicates with the blower fan (70) and guides air to flow in a lateral direction of the base bracket (50);
a second region (80b) that is bent in a vertical direction of the base bracket (50) and guides air to be discharged to an outside;
a third region (80c) that extends from the first region (80a) and changes a flow direction of air passing through the first region (80a); and
a fourth region (80d) that extends from the third region (80c), communicates with the second region (80b), and changes a flow direction of air passing through the third region (80c).

6. The electric range of claim 5,
wherein the air guide (80) includes:
a pair of first sidewalls (810) facing two sides of the heat sink (60); and
an upper wall (820) coupled to upper ends of the pair of first sidewalls (810) to cover the heat sink (60).

7. The electric range of claim 6, wherein, in the air guide (80):
the third region (80c) is formed so that the first sidewalls (810) are bent to be inclined at an end portion of the first region (80a); and
the fourth region (80d) is formed so that the first sidewalls (810) are bent to be inclined at an end portion of the third region (80c).

8. The electric range of claim 6 or 7, wherein:
the upper wall (820) is bent downward in the second region (80b); and
the air guide (80) is configured to guide air discharged from the second region (80b) toward a portion of the case (10).

9. The electric range of any one of claims 6 to 8, wherein the base bracket (50) includes:
a first ventilation portion (510) formed in a portion corresponding to the blower fan (70); and
a second ventilation portion (520) formed in a portion corresponding to the second region (80b).

10. The electric range of claim 9, wherein the case (10) includes:
a plurality of first through ports (140) formed in a portion corresponding to the first ventilation portion (510); and
a plurality of second through ports (150) formed in a portion corresponding to the second ventilation portion (520).

11. The electric range of any one of claims 6 to 10, wherein a longitudinal direction of the heat sink (60) is parallel to a flow direction of air passing through the air guide (80).

12. The electric range of claim 11, wherein the heat sink (60) includes a plurality of cooling fins (610) that protrudes downward from a lower surface of the heat sink (60) and extends in a longitudinal direction of the heat sink (60).

## Patentansprüche

1. Elektroherd, der aufweist:
ein Gehäuse (10);
eine Abdeckplatte (20), die mit einer Oberseite des Gehäuses (10) gekoppelt ist und eine obere Fläche aufweist, auf der ein Erwärmungsziel angeordnet werden kann;
mehrere Heizteile (30), die unter der Abdeckplatte (20) angeordnet und konfiguriert sind, das Erwärmungsziel zu erwärmen;
eine obere Halterung (40), die unter den mehreren Heizteilen (30) angeordnet ist und die mehreren Heizteile (30) stützt; und
einer Luftführung (80), die einen Luftströmungsweg bildet, wobei die Luftführung (80) einen Elementinstallationsabschnitt (830) aufweist, der in einem Abschnitt der Luftführung (80) angeordnet ist;
eine Leiterplatte (93), um mit einer externen Vorrichtung drahtlos zu kommunizieren;
einen Gebläseventilator (70), der konfiguriert ist, Luft abzugeben; und
einen Kühlkörper (60), der auf einer Leiterplatte (51) installiert ist,
wobei die Leiterplatte (93) in dem Elementinstallationsabschnitt (830) installiert ist, und
wobei die Leiterplatte (93) als drahtlose Kommunikationsplatine vorgesehen ist, um drahtlos mit der externen Vorrichtung zu kommunizieren,
**dadurch gekennzeichnet, dass**
der Elementinstallationsabschnitt (830) in lateraler Richtung vorsteht und in dem die Leiterplatte (93) installiert ist,
der Elementinstallationsabschnitt (830) in einem Abschnitt angeordnet ist, der von einem Endabschnitt der oberen Halterung (40) in lateraler Richtung vorsteht,
der Elementinstallationsabschnitt (830) an einer Position angeordnet ist, die die Abdeckplatte (20) in vertikaler Richtung überlappt und eine Überlappung mit der oberen Halterung (40) vermeidet, und
eine obere Fläche der Leiterplatte (93) so angeordnet ist, dass sie der Abdeckplatte (20) zugewandt ist.

2. Elektroherd nach Anspruch 1,
wobei die Leiterplatte (93) integral mit der Luftführung (80) ausgebildet ist.

3. Elektroherd nach Anspruch 2, der ferner eine Steuerplatine (90) aufweist, die unter der Abdeckplatte (20) angeordnet ist, wobei der Elementinstallationsabschnitt (830) auf einer Seite der Steuerplatine (90) in lateraler Richtung angeordnet ist.

4. Elektroherd nach Anspruch 2 oder 3, wobei der Elementinstallationsabschnitt (830) aufweist:
eine Anordnungsnut (831), die nach unten konkav ist und in der die Leiterplatte (93) angeordnet ist;
eine Elementstütze (832), der innerhalb der Anordnungsnut (831) angeordnet ist und eine Unterseite der Leiterplatte (93) stützt; und
einen Installationshaken (833), der an einer Wandfläche ausgebildet ist, die die Anordnungsnut (831) bildet, und konfiguriert ist, es zu ermöglichen, dass die Leiterplatte (93) lösbar im Elementinstallationsabschnitt (830) installiert wird.

5. Elektroherd nach einem der Ansprüche 2 bis 4, der ferner eine Basishalterung (50) aufweist, auf der die Leiterplatte (51) installiert ist,
wobei die Luftführung (80) aufweist:
einen ersten Bereich (80a), der mit dem Gebläseventilator (70) in Verbindung steht und Luft so führt, dass sie in einer lateralen Richtung der Basishalterung (50) strömt;
einen zweiten Bereich (80b), der in vertikaler Richtung der Basishalterung (50) gebogen ist und Luft so führt, dass sie nach außen abgegeben wird;
einen dritten Bereich (80c), der sich vom ersten Bereich (80a) erstreckt und die Strömungsrichtung der durch den ersten Bereich (80a) strömenden Luft ändert; und
einen vierten Bereich (80d), der sich vom dritten Bereich (80c) erstreckt, mit dem zweiten Bereich (80b) in Verbindung steht und die Strömungsrichtung der durch den dritten Bereich (80c) strömenden Luft ändert.

6. Elektroherd nach Anspruch 5,
wobei die Luftführung (80) aufweist:
ein Paar erster Seitenwände (810), die zwei Seiten des Kühlkörpers (60) zugewandt sind; und
eine obere Wand (820), die mit den oberen Enden des Paares der ersten Seitenwände (810) gekoppelt ist, um den Kühlkörper (60) abzudecken.

7. Elektroherd nach Anspruch 6, wobei in der Luftführung (80):
der dritte Bereich (80c) so ausgebildet ist, dass die ersten Seitenwände (810) gebogen sind, so dass sie an einem Endabschnitt des ersten Bereichs (80a) geneigt sind; und
der vierte Bereich (80d) so ausgebildet ist, dass die ersten Seitenwände (810) gebogen sind, so dass sie an einem Endabschnitt des dritten Bereichs (80c) geneigt sind.

8. Elektroherd nach Anspruch 6 oder 7, wobei:
die obere Wand (820) im zweiten Bereich (80b) nach unten gebogen ist; und
die Luftführung (80) konfiguriert ist, aus dem zweiten Bereich (80b) abgegebene Luft zu einem Abschnitt des Gehäuses (10) zu führen.

9. Elektroherd nach einem der Ansprüche 6 bis 8, wobei die Basishalterung (50) aufweist:
einen ersten Belüftungsabschnitt (510), der in einem Abschnitt ausgebildet ist, der dem Gebläseventilator (70) entspricht; und
einen zweiten Belüftungsabschnitt (520), der in einem Abschnitt ausgebildet ist, der dem zweiten Bereich (80b) entspricht.

10. Elektroherd nach Anspruch 9, wobei das Gehäuse (10) aufweist:
mehrere erste Durchgangsöffnungen (140), die in einem Abschnitt ausgebildet sind, der dem ersten Belüftungsabschnitt (510) entspricht; und
mehrere zweite Durchgangsöffnungen (150), die in einem Abschnitt ausgebildet sind, der dem zweiten Belüftungsabschnitt (520) entspricht.

11. Elektroherd nach einem der Ansprüche 6 bis 10, wobei eine Längsrichtung des Kühlkörpers (60) parallel zu einer Strömungsrichtung der durch die Luftführung (80) strömenden Luft verläuft.

12. Elektroherd nach Anspruch 11, wobei der Kühlkörper (60) mehrere Kühlrippen (610) aufweist, die von einer Unterseite des Kühlkörpers (60) nach unten vorstehen und sich in Längsrichtung des Kühlkörpers (60) erstrecken.

## Revendications

1. Cuisinière électrique, comprenant :
un boîtier (10) ;
une plaque de couverture (20) fixée à la face supérieure du boîtier (10) et présentant une surface supérieure sur laquelle peut être disposé un article à chauffer ;
une pluralité d'éléments chauffants (30) disposés sous la plaque de couverture (20) et prévus pour chauffer l'article à chauffer ;
un support supérieur (40) disposé sous la pluralité d'éléments chauffants (30) et supportant ladite pluralité d'éléments chauffants (30) ; et
un guide d'air (80) formant un passage d'écoulement d'air, ledit guide d'air (80) comprenant une partie d'installation d'élément (830) disposée dans une partie du guide d'air (80) ;
une carte de circuit imprimé (93) destinée à communiquer sans fil avec un dispositif externe ;
un ventilateur de soufflage (70) prévu pour refouler de l'air ; et
un dissipateur de chaleur (60) installé sur une carte de circuit imprimé (51),
où la carte de circuit imprimé (93) est installée dans la partie d'installation d'élément (830), et
où la carte de circuit imprimé (93) est prévue comme carte de communication sans fil afin de communiquer sans fil avec le dispositif externe,
**caractérisée en ce que**
la partie d'installation d'élément (830) fait saillie dans une direction latérale et la carte de circuit imprimé (93) est installée dans celle-ci,
la partie d'installation d'élément (830) est disposée dans une partie faisant saillie d'une extrémité du support supérieur (40) dans une direction latérale,
la partie d'installation d'élément (830) est disposée à un emplacement recouvrant la plaque de couverture (20) dans la direction verticale en évitant de recouvrir le support supérieur (40), et
une surface supérieure de la carte de circuit imprimé (93) est prévue de manière à être opposée à la plaque de couverture (20).

2. Cuisinière électrique selon la revendication 1,
où la carte de circuit imprimé (93) est formée d'un seul tenant avec le guide d'air (80).

3. Cuisinière électrique selon la revendication 2, comprenant en outre un panneau de commande (90) disposé sous la plaque de couverture (20), la partie d'installation d'élément (830) étant disposée sur un côté du panneau de commande (90) dans la direction latérale.

4. Cuisinière électrique selon la revendication 2 ou la revendication 3, où la partie d'installation d'élément (830) comprend :
une rainure de réception (831) concave vers le bas et où est disposée la carte de circuit imprimé (93) ;
un support d'élément (832) disposé à l'intérieur de la rainure de réception (831) et supportant une surface inférieure de la carte de circuit imprimé (93) ; et
un crochet de montage (833) formé sur une surface de paroi définissant la rainure de réception (831) et prévu pour permettre à la carte de circuit imprimé (93) d'être montée de manière amovible dans la partie d'installation d'élément (830).

5. Cuisinière électrique selon l'une des revendications 2 à 4, comprenant en outre un support de base (50) sur lequel est installée la carte de circuit imprimé (51),
où le guide d'air (80) comprend :
une première zone (80a) communiquant avec le ventilateur de soufflage (70) et guidant l'air pour qu'il s'écoule dans une direction latérale du support de base (50) ;
une deuxième zone (80b) pliée dans la direction verticale du support de base (50) et guidant l'air pour qu'il soit refoulé vers l'extérieur ;
une troisième zone (80c) s'étendant depuis la première zone (80a) et modifiant la direction d'écoulement de l'air traversant la première zone (80a) ; et
une quatrième zone (80d) s'étendant depuis la troisième zone (80c), communiquant avec la deuxième zone (80b) et modifiant la direction d'écoulement de l'air traversant la troisième zone (80c).

6. Cuisinière électrique selon la revendication 5,
où le guide d'air (80) comprend :
une paire de premières parois latérales (810) faisant face à deux côtés du dissipateur de chaleur (60) ; et
une paroi supérieure (820) raccordée aux extrémités supérieures de la paire de premières parois latérales (810) de manière à recouvrir le dissipateur de chaleur (60).

7. Cuisinière électrique selon la revendication 6, où, dans le guide d'air (80) :
la troisième zone (80c) est formée de sorte que les premières parois latérales (810) sont pliées de manière à être inclinées au niveau d'une partie d'extrémité de la première zone (80a) ; et
la quatrième zone (80d) est formée de telle sorte que les premières parois latérales (810) soient courbées de manière à être inclinées à une partie d'extrémité de la troisième zone (80c).

8. Cuisinière électrique selon la revendication 6 ou la revendication 7, où :
la paroi supérieure (820) est pliée vers le bas dans la deuxième zone (80b) ; et
le guide d'air (80) est prévu pour diriger l'air évacué de la deuxième zone (80b) vers une partie du boîtier (10).

9. Cuisinière électrique selon l'une des revendications 6 à 8, où le support de base (50) comprend :
une première partie de ventilation (510) formée dans une partie correspondant au ventilateur de soufflage (70) ; et
une deuxième partie de ventilation (520) formée dans une partie correspondant à la deuxième zone (80b).

10. Cuisinière électrique selon la revendication 9, où le boîtier (10) comprend :
une pluralité de premiers orifices traversants (140) formés dans une zone correspondant à la première partie de ventilation (510) ; et
une pluralité de deuxièmes orifices traversants (150) formés dans une zone correspondant à la deuxième partie de ventilation (520).

11. Cuisinière électrique selon l'une des revendications 6 à 10, où la direction longitudinale du dissipateur de chaleur (60) est parallèle à la direction d'écoulement de l'air traversant le guide d'air (80).

12. Cuisinière électrique selon la revendication 11, où le dissipateur de chaleur (60) comprend une pluralité d'ailettes de refroidissement (610) faisant saillie vers le bas depuis une surface inférieure du dissipateur de chaleur (60) et s'étendant dans la direction longitudinale du dissipateur de chaleur (60).
